(19) European Patent Office
Office européen des brevets

(11) **EP 1 413 908 A2**

(12) **EUROPEAN PATENT APPLICATION**

(43) Date of publication:
**28.04.2004 Bulletin 2004/18**

(51) Int Cl.7: **G02B 13/14**, G02B 17/08, G03F 7/20

(21) Application number: **03023866.1**

(22) Date of filing: **21.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **21.10.2002 JP 2002305211**

(71) Applicant: **Nikon Corporation**
**Tokyo 100-8331 (JP)**

(72) Inventor: **Takahashi, Tomowaki**
**Chiyoda-ku Tokyo 100-8331 (JP)**

(74) Representative: **HOFFMANN - EITLE**
**Patent- und Rechtsanwälte**
**Arabellastrasse 4**
**81925 München (DE)**

(54) **Projection optical system and exposure apparatus equipped with the projection optical system**

(57) A reflective type projection optical system has good reflection characteristics with X rays and can correct aberrations well while controlling the size of reflective mirrors. The projection optical system includes six reflective mirrors and forms a reduced image of a first plane onto a second plane. The system includes a first reflective image forming optical system (G1) for forming an intermediate image of the first plane and a second reflective image forming optical system (G2) for forming an image of the intermediate image of the second plane. The first reflective image forming optical system has, in order of an incidence of light from the side of the first plane, a first reflective mirror (M1), an aperture stop (AS), a second reflective mirror (M2), a third reflective mirror (M3), and a fourth reflective mirror (M4). The second reflective image forming optical system has, in order of the incidence of the light from the side of the first plane, a fifth reflective mirror (M5) and a sixth reflective mirror (M6).

Fig. 3

**Description**

Incorporation by Reference

This application is based on Japanese Patent Application 2002-305211 filed October 21, 2002, the disclosure of which is incorporated herein by reference in its entirety.

BACKGROUND OF THE INVENTION

1. Field of Invention

This invention relates to projection optical systems and exposure apparatus equipped with projection optical systems. In particular, this invention relates to reflective projection optical systems that are optimum for X-ray projection exposure systems that transfer a circuit pattern on a mask onto a photosensitive substrate by a mirror projection method using X-rays, for example.

2. Description of Related Art

Conventionally, in an exposure apparatus used in manufacturing semiconductor elements and the like, a circuit pattern formed on a mask (reticle) is projected and transferred on a photosensitive substrate, such as a wafer, through a projection optical system. The photosensitive substrate is coated by resist, and the resist is exposed by projection exposure through the projection optical system to obtain a resist pattern that corresponds to the mask pattern.
Here, a resolution W of the exposure apparatus depends on a wavelength $\lambda$ of exposure light and a numerical aperture NA of the projection optical system and can be represented by the following equation (a).

$$W = k \cdot \lambda / NA \ (k: constant) \tag{a}$$

Therefore, to increase the resolution of the exposure apparatus, it is necessary to shorten the wavelength $\lambda$ of the exposure light or enlarge the numerical aperture NA of the projection optical system (or both). In general, it is difficult from a point of view of optical designing to increase the numerical aperture NA of the projection optical system to more than a predetermined value. Therefore, it is necessary to shorten the wavelength of the exposure light in the future. For example, a resolution of 0.25 $\mu$m is obtained when a KrF excimer laser having a wavelength of 248 nm is used as the exposure light, and a resolution of 0.18 $\mu$m is obtained when an ArF excimer laser having a wavelength of 193 nm is used. If an X ray that has an even shorter wavelength is used as the exposure light, for example, a resolution of 0.1 $\mu$m or less can be obtained at a wavelength of 13 nm.
When the X ray is used as the exposure light, because there are few usable transmissive optical materials or refractive optical materials, a reflective mask is used while a reflective type (catoptric) projection optical system is used. As projection optical systems that can be appropriately used in an exposure apparatus that uses X rays as the exposure light, various reflective optical systems have been proposed, for example, in Japanese Laid-Open Patent Application No. 61-47914, U.S. Patent No. 5,815,310, Japanese Laid-Open Patent Application No. 9-211322, U.S. Patent No. 5,686,728, Japanese Laid-Open Patent Application No. 10-90602, and WO99/57606.
However, the reflective optical system disclosed in Japanese Laid-Open Patent Application No. 61-47914 has a form in which a mask and a wafer are located in an optical system. Therefore, it is extremely difficult to realize as a projection optical system for an exposure apparatus.
The reflective optical system disclosed in U.S. Patent No. 5,815,310, Japanese Laid-Open Patent Application No. 9-211322 and WO 99/57606 has a form in which the optical system is positioned between the mask and the wafer, but a part of a reflective mirror is large, so that an effective diameter of the reflective mirror substantially is larger than the effective diameter of the mask. Thus, manufacture of such a system is difficult.
Furthermore, in the reflective optical systems disclosed in U.S. Patent No. 5,686,728 and Japanese Laid-Open Patent Application No. 10-90602 has a form in which the optical system is positioned between the mask and the wafer, but a part of a reflective mirror is large, so that an effective diameter of the reflective mirror substantially is larger than the effective diameter of the mask. In addition, two convex reflective mirrors are used at the wafer side, an angle of light beam with respect to an optical axis is large, resulting in an enlarged reflective mirror.
When a projection optical system is installed in an exposure apparatus that uses X rays as exposure light, a multi-layer film formed by tens of layers is formed on a reflective surface to improve the reflection of the X rays. In the prior reflective optical system, the maximum incident angle of the light beam to the reflective surface of each reflective mirror (an angle defined between the light beam and a line perpendicular to the reflective surface) is set relatively large.

As a result, because uneven reflection easily occurs and a sufficiently high reflection rate cannot be obtained using the reflection multi-layer film, good (suitable) reflection characteristics cannot be achieved.

SUMMARY OF THE INVENTION

This invention is made in consideration of the above-described problems and has an object to provide a reflective type projection optical system that can limit the size of the reflective mirror and perform suitable aberration correction. This invention also has an object to provide an exposure apparatus that can obtain high resolution using an X ray as exposure light, by including the projection optical system of this invention in the exposure apparatus.

One aspect of this invention provides a projection optical system having six reflective mirrors, for forming a reduced image on a first plane onto a second plane, and includes a first reflective image forming optical system for forming an intermediate image of the first plane, and a second reflective image forming optical system for forming an image of the intermediate image onto the second plane. The first reflective image forming optical system has, in order of an incidence of light from the side of the first plane, a first reflective mirror M1, an aperture stop, a second reflective mirror M2, a third reflective mirror M3, and a fourth reflective mirror M4 The second reflective image forming optical system has, in order of the incidence of the light from the side of the first plane, a fifth reflective mirror M5 and a sixth reflective mirror M6.

According to a preferred embodiment of the first aspect of the invention, the maximum incident angle of a light beam to each of the reflective mirrors M1-M6 satisfies a condition of $A < 25°$ at each of the reflective mirrors M1-M6. In addition, it is preferable that at each of the reflective mirrors M1-M6, a condition of $\phi M / | R | < 1.0$ is satisfied, where $\phi M$ is an effective diameter of each of the reflective mirrors M1-M6, and R is a curvature radius of the reflective surface of each of the reflective mirrors M1-M6.

Furthermore, according to a preferred embodiment of the first aspect of the invention, a slope $\alpha$ of a luminous flux from the first plane to the first reflective mirror M1 with respect to an optical axis of a main light beam satisfies $5° < | \alpha | < 10°$. In addition, it is preferable that at each of the reflective mirrors M1-M6, the effective diameter $\phi M$ of each of the reflective mirrors M1-M6 satisfies $\phi M \leq 700$ mm.

In addition, according to a preferred embodiment of the first aspect of the invention, the reflective surface of each of the reflective mirrors M1-M6 is formed rotationally symmetrical with respect to the optical axis and aspheric, and the largest order of an aspheric surface defining each reflective surface is equal to or more than 10th order. Furthermore, it is preferable that the projection optical system is an optical system that is substantially telecentric on the second plane side.

In a second aspect of this invention, an exposure apparatus is provided that includes an illumination system for illuminating a mask provided on the first plane, and the projection optical system of the first aspect of the invention for projecting and exposing a pattern of the mask onto a photosensitive substrate provided on the second plane.

According to a preferred embodiment of the second aspect of the invention, the illumination system has a light source for providing X rays as exposure light, and the pattern of the mask is projected and exposed onto the photosensitive substrate by mutually (and synchronously) moving the mask and the photosensitive substrate with respect to the projection optical system.

BRIEF DESCRIPTION OF THE DRAWINGS

The invention will be described in detail with reference to the following drawings, in which like reference numerals are used to identify similar elements, and wherein:

Fig. 1 is a figure schematically showing a structure of an exposure apparatus according to an exemplary embodiment of this invention;

Fig. 2 is a diagram showing positional relationships between a circular arc shaped exposure region (i.e., effective exposure region) formed on a wafer and an optical axis;

Fig. 3 is a diagram showing a structure of a projection optical system according to the first exemplary embodiment;

Fig. 4 is a figure showing comas in the projection optical system of the first exemplary embodiment;

Fig. 5 is a diagram showing a structure of a projection optical system according to a second exemplary embodiment of the invention;

Fig. 6 is a diagram showing comas in the projection optical system of the second exemplary embodiment;

Fig. 7 is a diagram showing a structure of a projection optical system according to a third exemplary embodiment of the invention;

Fig. 8 is a diagram showing comas in the projection optical system of the third exemplary embodiment; and

Fig. 9 is a figure showing a flow chart for an exemplary method for manufacturing semiconductor devices as micro devices.

DETAILED DESCRIPTION OF PREFERRED EMBODIMENTS

In the projection optical system of this invention, light from a first plane (object plane) forms an intermediate image of the first plane through a first reflective image forming optical system G1. The light from the intermediate image of the first plane formed through the first reflective image forming optical system G1 then forms an image of the intermediate image as a reduced image of the first plane onto a second plane (image plane) through a second reflective image forming optical system G2.

The first reflective image forming optical system G1 includes a first reflective mirror M1 for reflecting light from the first plane, an aperture stop AS, a second reflective mirror M2 for reflecting the light reflected by the first reflective mirror M1, a third reflective mirror M3 for reflecting the light reflected by the second reflective mirror M2, and a fourth reflective mirror M4 for reflecting the light reflected by the third reflective mirror M3 to form an intermediate image of the first plane. The second reflective image forming optical system G2 includes a fifth reflective mirror M5 for reflecting the light from the intermediate image, and a sixth concave reflective mirror M6 for reflecting the light reflected by the fifth reflective mirror M5.

In this invention, by using a structure in which a reduced image of the first plane is formed on the second plane by two-step image formation, distortions can be corrected well. Moreover, since an aperture stop AS is positioned in an optical path between the first reflective mirror M1 and the second reflective mirror M2, an incident angle of the light beam to the third reflective mirror M3, at which the incident angle of the light beam tends to become large, is kept small. Normally, in an optical system structured from six mirrors, an aperture stop is generally positioned immediately before the first reflective mirror to avoid interference with the luminous flux. In this case, the position of the stop is limited, and thus it becomes difficult to balance the upper coma and the lower coma. On the other hand, in this invention, since the aperture stop AS is positioned between the first reflective mirror M1 and the second reflective mirror M2, a degree of freedom for the position of the stop is secured, and the upper coma and the lower coma are more easily balanced. Moreover, if the aperture stop AS is positioned between the second reflective mirror M2 and the third reflective mirror M3 or between the third reflective mirror M3 and the fourth reflective mirror M4, an effective diameter of the first reflective mirror M1 becomes large. Furthermore, because the incident angle to the reticle and the reflection angle from the reticle are predetermined, the length of the optical path from the reticle to an exit pupil (aperture stop) becomes long, and an object height of the reticle becomes high. As a result, an image formation magnification has to be set at 1/5-1/6. On the other hand, in this invention, when the aperture stop AS is positioned between the first reflective mirror M1 and the second reflective mirror M2, excellent optical characteristics can be realized while keeping the image formation magnification smaller, for example, at 1/4. As a result, because uneven reflection hardly occurs and sufficiently high reflectivity can be obtained in a reflective multi-layer film, good reflection characteristics can be secured even for X rays.

In addition, by controlling the incident angle of the light beam to the third reflective mirror M3, an effective diameter of the fourth reflective mirror M4, which has an effective diameter that tends to become large, can be kept small. As described above, in this invention, a reflective type projection optical system that has excellent reflection characteristics for X rays and can correct aberrations well while controlling the size of the reflective mirrors.

In this invention, it is preferable that the maximum incident angle A of the light beam to each of the reflective mirrors M1-M6 satisfies the following conditional equation (1) at each of the reflective mirrors M1-M6:

$$A < 25° \tag{1}$$

If the upper value of the conditional equation (1) is exceeded, the maximum incident angle A of the light beam to the reflective multi-layer film becomes too large, uneven reflection more easily occurs, and sufficiently high reflectivity cannot be obtained. This is not preferred.

In addition, in this invention, it is preferable that the following conditional equation (2) is satisfied at each of the reflective mirrors M1-M6. In the conditional equation (2), $\phi M$ is an effective diameter of each of the reflective mirrors M1-M6 and R is a curvature radius of the reflective surface of each of the reflective mirrors M1-M6.

$$\phi M / |R| < 1.0 \tag{2}$$

If the upper value of the conditional equation (2) is exceeded, an open angle at the time of measurement of the shape of each of the reflective mirrors M1-M6 (especially the fourth reflective mirror M4) (NA at the time of measurement of the reflective mirrors) becomes too large, and thus, it becomes difficult to measure the shape with high accuracy. Hence, this is not preferred. In addition, it is more preferable to set the upper value of the conditional equation (2) at 0.45, to allow the measurement of the shape with very high accuracy.

EP 1 413 908 A2

In addition, it is preferable that a slope α of luminous flux from the first plane to the first reflective mirror M1 with respect to an optical axis of a main light beam satisfies the following conditional equation (3).

$$5° < | \alpha | < 10°$$ (3)

If the upper value of the conditional equation (3) is exceeded, it is not preferable because it becomes easy to be affected by shadow caused by reflection when a reflective mask is provided on the first plane. On the other hand, if the slope goes below the lower value of the conditional equation (3), it is not preferable because the incident light and the reflected light interfere when the reflective mask is provided on the first plane.

In addition, in this invention, it is preferable that at each of the reflective mirrors M1-M6, the effective diameter φM of each of the reflective mirrors M1-M6 satisfies the following conditional equation (4).

$$\phi M \leq 700 \text{ mm}$$ (4)

If the upper value of the conditional equation (4) is exceeded, it is not preferable because the effective diameter of the reflective mirror becomes too large, and thus the optical system becomes large.

Furthermore, in this invention, it is preferable that the reflective surface of each of the reflective mirrors M1-M6 is formed rotationally symmetrical with respect to the optical axis and aspheric, and that the largest order of an aspheric surface defining each reflective surface is equal to or more than 10th order. In addition, in this invention, it is preferable that the projection optical system is an optical system that is substantially telecentric on the second plane side. By this structure, when this invention is included in an exposure apparatus, for example, excellent image formation becomes possible even if the wafer is uneven within the depth of focus of the projection optical system.

In addition, by adapting the projection optical system of this invention in an exposure apparatus, X rays can be used as exposure light. In this case, the pattern of a mask is projected and exposed on a photosensitive substrate by mutually (and synchronously) moving the mask and the photosensitive substrate with respect to the projection optical system. As a result, highly precise micro devices can be manufactured under excellent exposure conditions by using a scanning type exposure apparatus that has high resolution.

An exemplary embodiment of this invention now is described based on the attached drawings.

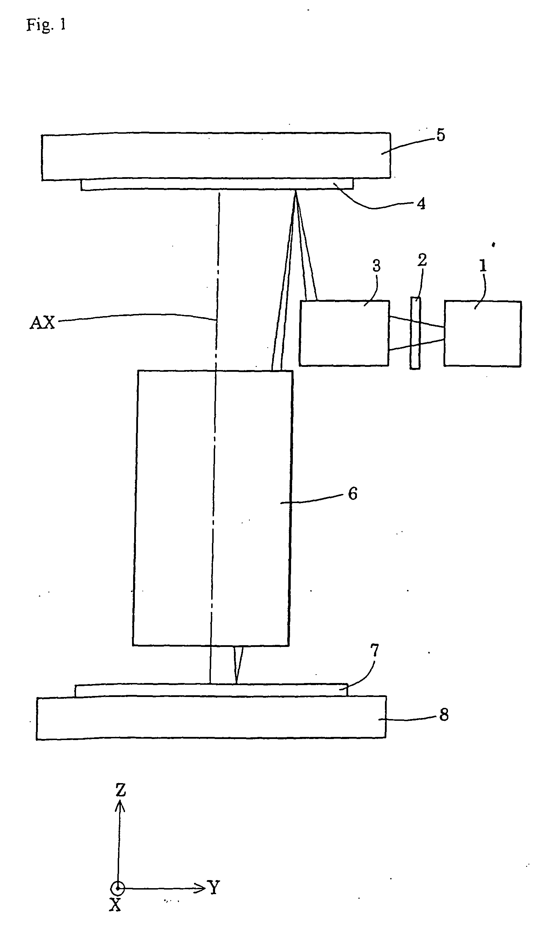

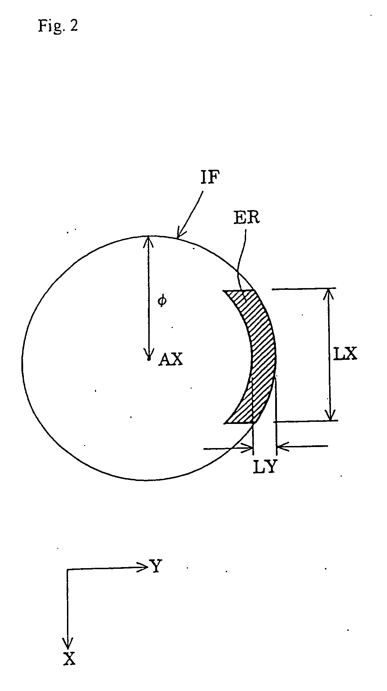

Fig. 1 is a figure showing schematically a structure of an exposure apparatus according to one exemplary embodiment of this invention. In addition, Fig. 2 is a figure showing positional relationships between a circular arc shaped exposure region formed on a wafer (i.e., an effective exposure region) and an optical axis. In Fig. 1, the Z axis is set as the optical axis direction of the projection optical system, that is, a direction that is normal to the plane of the wafer which is a photosensitive substrate; the Y axis is set in a direction in the wafer surface that is parallel to the plane of the paper containing Fig. 1; and the X axis is set in a direction in the wafer surface that is perpendicular to the plane of the paper containing Fig. 1.

The exposure apparatus shown in Fig. 1 is equipped with a laser plasma X-ray source 1, for example, as a light source for supplying the exposure light. The light emitted from the X-ray source 1 enters into an illumination optical system 3 through a wavelength selection filter 2. The wavelength selection filter 2 has characteristics to allow the X ray having a predetermined wavelength (e.g., 13.5 nm) from the light supplied by the X-ray source 1 to be selectively transmitted and to block the transmission of light having other wavelengths.

The X ray that has transmitted through the wavelength selection filter illuminates a reflective type mask 4 on which a pattern to be transferred is formed, through the illumination optical system 3 structured from a plurality of reflective mirrors. The mask 4 is held by a mask stage 5 that is movable along the Y direction such that the pattern surface extends along the XY plane. The movement of the mask stage is measured by a laser interferometer, which is omitted from the drawing. Therefore, a circular arc shaped illumination region that is symmetrical with respect to the Y axis (as shown in Fig. 2) is formed on the mask 4.

The light from the pattern of the mask 4 forms an image of the mask pattern on a wafer 7 that is the photosensitive substrate, through the reflective type projection optical system 6. That is, as shown in Fig. 2, a circular arc shaped exposure region ER that is symmetrical with respect to the Y axis is formed on the wafer 7. Referring to Fig. 2, in the circular shaped region (image circle) IF that has a radius φ about the optical axis AX as a center, the circular arc shaped effective exposure region (ER) has a length in the X direction that is LX and a length in the Y direction that is LY, and is configured such that the region ER contacts the image circle IF.

The wafer 7 is held by a wafer stage 8 that is movable two-dimensionally along the X and Y directions, so that the exposure surface extends along the XY plane. In addition, similar to the mask stage 5, the movement of the wafer stage 8 is measured by a laser interferometer, which is omitted from the drawing. As a result, by performing a scanning exposure while the mask stage 5 and the wafer stage 8 are moved along the Y direction, that is, while relatively and synchronously moving the mask 4 and the wafer 7 with respect to the projection optical system 6 along the Y direction, the pattern of the mask 4 is transferred to one exposure region of the wafer 7.

At this time, if the projection magnification (transfer magnification) of the projection optical system 6 is 1/4, the synchronous scan is performed by setting the moving speed of the wafer stage 8 at 1/4 of the moving speed of the mask stage 5. Moreover, by repeating the scan exposure while two-dimensionally moving the wafer stage 8 along the X and Y directions, the pattern of the mask is sequentially transferred to each exposure region of the wafer 7. Referring to the first-third exemplary embodiments, a detailed structure of the projection optical system 6 is described below.

In each exemplary embodiment, the projection optical system 6 is structured from a first reflective image forming optical system G1 for forming an intermediate image of the pattern of the mask 4, and a second reflective image forming optical system G2 for forming an image of the intermediate image of the mask pattern (a secondary the image of the pattern of the mask 4) on the wafer 7. The first reflective image forming optical system G1 is structured from four reflective mirrors M1-M4, and the second reflective image forming optical system G2 is structure from two reflective mirrors M5 and M6.

In addition, in each exemplary embodiment, a reflective surface of all of the reflective mirrors is formed rotationally symmetrical about the optical axis and is aspheric. Furthermore, an aperture stop AS is positioned in an optical path that extends from the first reflective mirror M1 to the second reflective mirror M2. Moreover, in each exemplary embodiment, the projection optical system 6 is an optical system that is telecentric on the wafer side.

In each exemplary embodiment, when the height in a direction perpendicular to the optical axis is y, a distance from a plane tangent to the apex of the aspheric surface to the position on the aspheric surface at the height y along the optical axis (sag amount) is z, a radius of curvature at apex is r, and a conical coefficient is $\kappa$, and the n-th order aspheric coefficient is Cn, the aspheric surface is represented by the following formula (b).

[Equation 1]

$$z = (y^2/r)/\{1+\{1-(1+\kappa)\cdot y^2/r^2\}^{1/2}\}$$

$$+C_4\cdot y^4 + C_6\cdot y^6 + C_8\cdot y^8 + C_{10}\cdot y^{10} + ...(b)$$

[First Exemplary Embodiment]

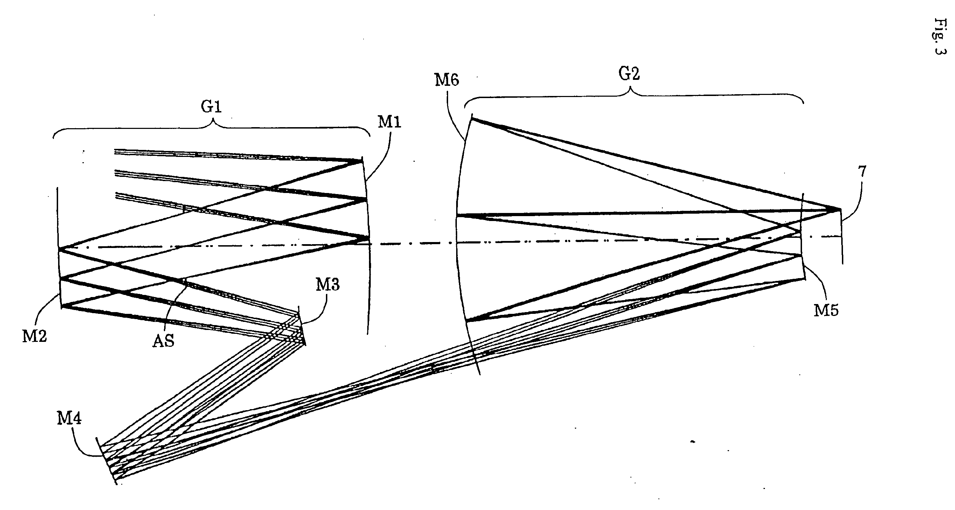

Fig. 3 is a drawing showing a structure of a projection optical system according to a first exemplary embodiment. Referring to Fig. 3, in the projection optical system of the first embodiment, the light from the mask 4 (not shown in Fig. 3) forms an intermediate image of the mask pattern after being sequentially reflected by reflective surfaces of the first concave reflective mirror M1, the second concave reflective mirror M2, the third convex reflective mirror M3 and the fourth concave reflective mirror M4. The light from the intermediate image of the mask pattern formed through the first reflective image forming optical system G1 forms a reduced image (secondary image) of the mask pattern on the wafer 7 after being sequentially reflected by reflective surfaces of the fifth convex reflective mirror M5 and the sixth concave reflective mirror M6.

Parameters for the projection optical system according to the first exemplary embodiment are shown in the following Table (1). In Table (1), $\lambda$ represents the wavelength of the exposure light; $\beta$ represents the projection magnification; NA represents an image side (wafer side) numerical aperture; H0 represents the maximum object height on the mask 4; $\phi$ represents the radius (maximum image height) of the image circle IF on the wafer 7; LX represents a measurement of the effective exposure region ER along the X direction; and LY represents a measurement of the effective exposure region ER along the Y direction.

In addition, surface numbers indicate an order of the reflective surfaces from the mask side along the direction of the light beam from the mask surface, which is an object surface, to the wafer surface, which is an image surface; r indicates an apex curvature radius (mm) of each reflective surface; and d indicates a space between each reflective surface on the axis, that is, a surface space (mm). The sign of the surface space d changes every time when the light beam is reflected. Regardless of the direction of the incidence of the light beam, the curvature radius of a convex surface is set positive and the curvature radius of a concave surface is set negative, facing the mask side.

[Table 1]

(Principle parameters)

$\lambda = 13.5$ nm

ß = 1/4

NA = 0.26

H0 = 124 mm

$\phi = 31$ mm

LX = 26 mm

LY = 2 mm

(Optical member parameters)

Surface number

| | r | d | |
|---|---|---|---|
| | (Mask surface) | 652.352419 | |
| 1 | −790.73406 | −209.979693 | (First reflecting mirror M1) |
| 2 | ∞ | −141.211064 | (Aperture stop AS) |
| 3 | 3000.00000 | 262.342040 | (Second reflecting mirror M2) |
| 4 | 478.68563 | −262.292922 | (Third reflecting mirror M3) |
| 5 | 571.53754 | 842.912526 | (Fourth reflecting mirror M4) |
| 6 | 296.70332 | −391.770887 | (Fifth reflecting mirror M5) |
| 7 | 471.35911 | 436.582453 | (Sixth reflecting mirror M6) |
| | (Wafer surface) | | |

(Aspheric surface data)

First surface

$\kappa = 0.000000$

$C_4 = 0.246505 \times 10^{-8}$     $C_6 = -0.446668 \times 10^{-13}$

$C_8 = 0.120146 \times 10^{-17}$     $C_{10} = -0.594987 \times 10^{-22}$

$C_{12} = 0.340020 \times 10^{-26}$     $C_{14} = 0.254558 \times 10^{-30}$

$C_{16} = -0.806173 \times 10^{-34}$     $C_{18} = 0.686431 \times 10^{-38}$

$C_{20} = -0.209184 \times 10^{-42}$

Third surface

$\kappa = 0.000000$

$C_4 = -0.413181 \times 10^{-9}$     $C_6 = 0.717222 \times 10^{-14}$

$C_8 = -0.713553 \times 10^{-19}$     $C_{10} = 0.255721 \times 10^{-21}$

$C_{12} = -0.495895 \times 10^{-24}$ $\qquad$ $C_{14} = 0.324678 \times 10^{-27}$

$C_{16} = -0.103419 \times 10^{-30}$ $\qquad$ $C_{18} = 0.164243 \times 10^{-34}$

$C_{20} = -0.104535 \times 10^{-38}$

Fourth surface

$\kappa = 0.000000$

$C_4 = -0.217375 \times 10^{-8}$ $\qquad$ $C_6 = 0.385056 \times 10^{-13}$

$C_8 = -0.347673 \times 10^{-17}$ $\qquad$ $C_{10} = 0.186477 \times 10^{-21}$

$C_{12} = -0.244210 \times 10^{-26}$ $\qquad$ $C_{14} = -0.704052 \times 10^{-30}$

$C_{16} = 0.833625 \times 10^{-34}$ $\qquad$ $C_{18} = -0.418438 \times 10^{-38}$

$C_{20} = 0.792241 \times 10^{-43}$

Fifth surface

$\kappa = 0.000000$

$C_4 = -0.380907 \times 10^{-10}$ $\qquad$ $C_6 = -0.334201 \times 10^{-15}$

$C_8 = 0.113527 \times 10^{-19}$ $\qquad$ $C_{10} = -0.535935 \times 10^{-25}$

$C_{12} = -0.416047 \times 10^{-29}$ $\qquad$ $C_{14} = 0.881874 \times 10^{-34}$

$C_{16} = -0.583757 \times 10^{-39}$ $\qquad$ $C_{18} = -0.780811 \times 10^{-45}$

$C_{20} = 0.176571 \times 10^{-49}$

Sixth surface

$\kappa = 0.000000$

$C_4 = -0.190330 \times 10^{-8}$ $\qquad$ $C_6 = 0.134021 \times 10^{-11}$

$C_8 = -0.471080 \times 10^{-16}$ $\qquad$ $C_{10} = -0.968673 \times 10^{-20}$

$C_{12} = 0.284390 \times 10^{-22}$ $\qquad$ $C_{14} = -0.265057 \times 10^{-25}$

$C_{16} = 0.131472 \times 10^{-28}$ $\qquad$ $C_{18} = -0.341329 \times 10^{-32}$

$C_{20} = 0.365714 \times 10^{-36}$

Seventh surface

$\kappa = 0.000000$

$C_4 = 0.668635 \times 10^{-10}$ $\qquad$ $C_6 = 0.359674 \times 10^{-15}$

$C_8 = 0.468613 \times 10^{-20}$ $\qquad$ $C_{10} = -0.440976 \times 10^{-24}$

$C_{12} = 0.431536 \times 10^{-28}$ $\qquad$ $C_{14} = -0.257984 \times 10^{-32}$

$C_{16} = 0.938415 \times 10^{-37}$ $\qquad$ $C_{18} = -0.190247 \times 10^{-41}$

$C_{20} = 0.165315 \times 10^{-46}$

(Conditional equation corresponding value)

$$\phi M4 = 493.843 \text{ mm}$$

$$R4 = 571.53754 \text{ mm}$$

$$(1) \ A = 21.03°$$

$$(2) \ \phi M / |R| = 0.864 \text{ (maximum at the fourth reflecting mirror M4)}$$

$$(3) \ |\alpha| = 6.016° \text{ (105 mrad)}$$

$$(4) \ \phi M = 493.843 \text{ mm (maximum at the fourth reflecting mirror M4)}$$

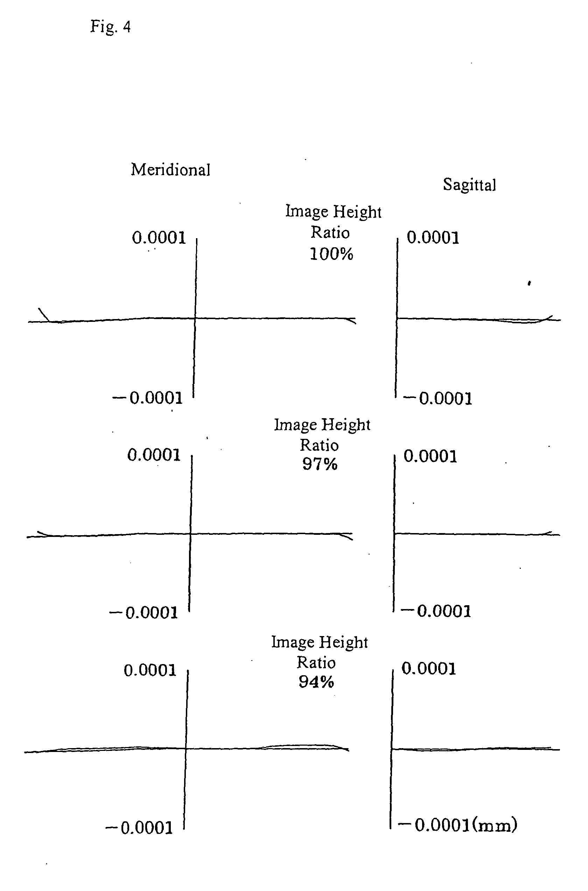

Fig. 4 is a figure showing coma in the projection optical system of the first exemplary embodiment. Fig. 4 shows meridional comas and sagittal comas at an image height of 100%, 97% and 94%, respectively. As is clear from the aberration diagrams, in the first exemplary embodiment, it is understood that the coma is corrected well in regions corresponding to the effective exposure region ER. In addition, although omitted from the drawing, it has been confirmed that various aberrations other than the coma, such as spherical aberration and distortions, are excellently corrected in the regions corresponding to the effective exposure region ER.

[Second Exemplary Embodiment]

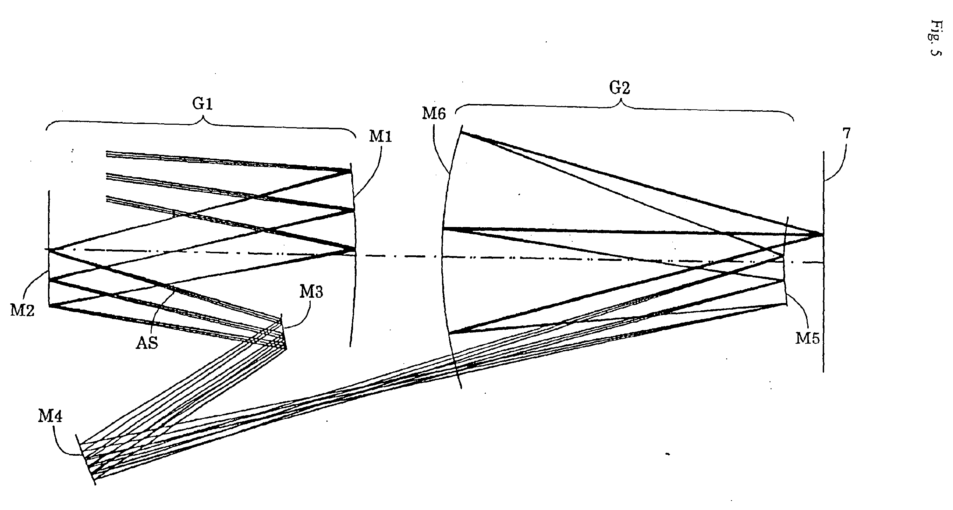

Fig. 5 is a figure showing a structure of a projection optical system according to a second exemplary embodiment. Referring to Fig. 5, in the projection optical system of the second exemplary embodiment, similar to that of the first exemplary embodiment, the light from the mask 4 (not shown in Fig. 5) forms an intermediate image of a mask pattern after being sequentially reflected by reflective surfaces of the first concave reflective mirror M1, the second concave reflective mirror M2, the third convex reflective mirror 3, and the fourth concave reflective mirror M4. The light from the intermediate image of the mask pattern formed through the first reflective image forming optical system G1 forms a reduced image (secondary image) of the mask pattern on the wafer 7 after being sequentially reflected by the reflective surfaces of the fifth convex reflective mirror M5 and the sixth concave reflective mirror M6.

Parameters for the projection optical system according to the second exemplary embodiment are shown in the following Table (2).

[Table 2]

(Principle parameters)

$$\lambda = 13.5 \text{ nm}$$

$$\beta = 1/4$$

$$NA = 0.26$$

H0 = 124 mm

$\phi$ = 3.1 mm

LX = 26 mm

LY = 2 mm

(Optical member parameters)

Surface number

| | | r | d | |
|---|---|---|---|---|
| | (Mask surface) | | 652.287522 | |
| 1 | | -787.44217 | -209.527897 | (First reflecting mirror M1) |
| 2 | | $\infty$ | -140.380205 | (Aperture Stop AS) |
| 3 | | 3000.00000 | 258.361844 | (Second reflecting mirror M2) |
| 4 | | 469.36430 | -262.681731 | (Third reflecting mirror M3) |
| 5 | | 570.54321 | 846.980968 | (Fourth reflecting mirror M4) |
| 6 | | 299.31443 | -392.752979 | (Fifth reflecting mirror M5) |
| 7 | | 471.59115 | 435.679282 | (Sixth reflecting mirror M6) |
| | (Wafer surface) | | | |

(Aspheric surface data)

First surface

$\kappa$ = 0.000000

$C_4 = 0.247869 \times 10^{-8}$ $\qquad$ $C_6 = -0.446870 \times 10^{-13}$

$C_8 = 0.958066 \times 10^{-18}$ $\qquad$ $C_{10} = -0.138288 \times 10^{-22}$

Third surface

$\kappa$ = 0.000000

$C_4 = -0.417360 \times 10^{-9}$ $\qquad$ $C_6 = 0.728058 \times 10^{-14}$

$C_8 = -0.321841 \times 10^{-18}$ $\qquad$ $C_{10} = 0.326202 \times 10^{-22}$

Fourth surface

$\kappa$ = 0.000000

$C_4 = -0.217867 \times 10^{-8}$ $\qquad$ $C_6 = 0.898857 \times 10^{-14}$

$C_8 = -0.435308 \times 10^{-18}$ $\qquad$ $C_{10} = 0.929250 \times 10^{-23}$

Fifth surface

$\kappa$ = 0.000000

$C_4 = -0.393210 \times 10^{-10}$ $\qquad$ $C_6 = 0.444510 \times 10^{-16}$

$C_8 = -0.128915 \times 10^{-20}$ $\qquad$ $C_{10} = 0.361021 \times 10^{-26}$

Sixth surface

$\kappa = 0.000000$

$C_4 = -0.194804 \times 10^{-8}$        $C_6 = 0.134157 \times 10^{-11}$

$C_8 = -0.446261 \times 10^{-16}$        $C_{10} = 0.293579 \times 10^{-20}$

Seventh surface

$\kappa = 0.000000$

$C_4 = 0.665708 \times 10^{-10}$        $C_6 = 0.369325 \times 10^{-15}$

$C_8 = 0.179080 \times 10^{-20}$        $C_{10} = 0.905639 \times 10^{-26}$

Conditional equation corresponding value

$\phi M4 = 495.552$ mm

$R4 = 570.54321$ mm

(1) $A = 21.13°$

(2) $\phi M / |R| = 0.869$ (maximum at the fourth reflecting mirror M4)

(3) $|\alpha| = 6.017°$ (105 mrad)

(4) $\phi M = 495.552$ mm (maximum at the fourth reflecting mirror M4)

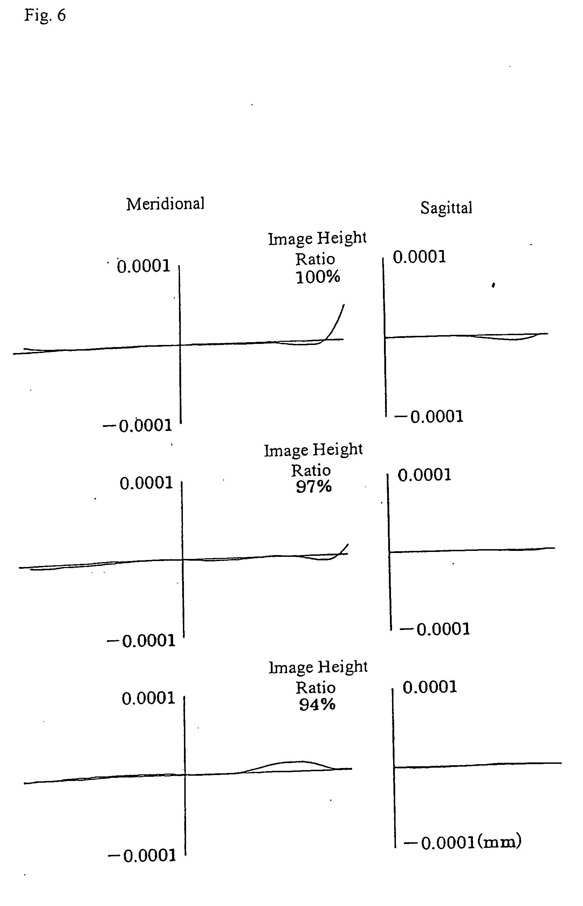

Fig. 6 is a figure showing coma in the projection optical system of the second exemplary embodiment. Fig. 6 shows meridional comas and sagittal comas at an image height of 100%, 97% and 94%, respectively. As is clear from the aberration diagrams, in the second exemplary embodiment, similar to the first exemplary embodiment, it is understood that the coma is corrected well in regions corresponding to the effective exposure region ER. In addition, although omitted from the drawing, it has been confirmed that various aberrations other than the coma, such as spherical aberration and distortions, are excellently corrected in the regions corresponding to the effective exposure region ER.

[Third Exemplary Embodiment]

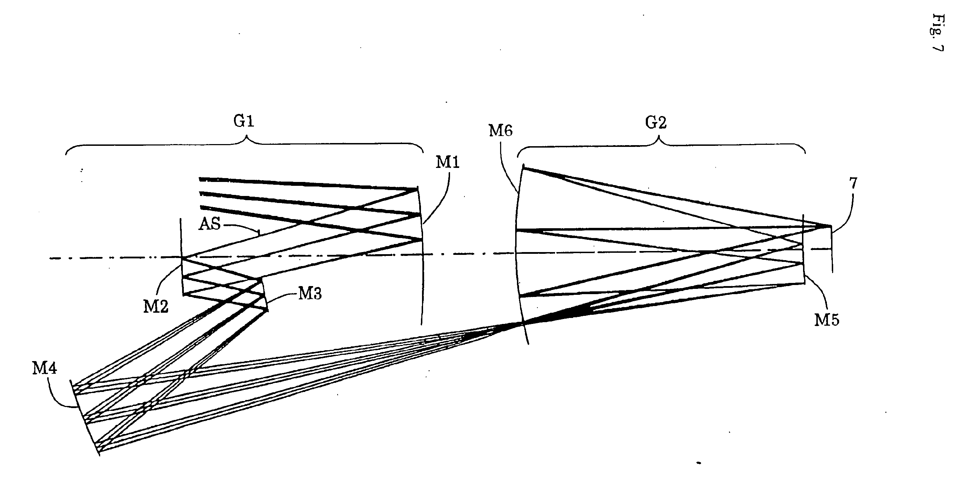

Fig. 7 is a figure showing a structure of a projection optical system according to a third exemplary embodiment. Referring to Fig. 7, in the projection optical system of the third exemplary embodiment, similar to that of the first and second exemplary embodiments, the light from the mask 4 (not shown in Fig. 7) forms an intermediate image of a mask pattern after being sequentially reflected by reflective surfaces of the first concave reflective mirror M1, the second concave reflective mirror M2, the third convex reflective mirror 3, and the fourth concave reflective mirror M4. The light from the intermediate image of the mask pattern formed through the first reflective image forming optical system G1 forms a reduced image (secondary image) of the mask pattern on the wafer 7 after being sequentially reflected by the reflective surfaces of the fifth convex reflective mirror M5 and the sixth concave reflective mirror M6.
Parameters for the projection optical system according to the third exemplary embodiment are shown in the following Table (3).

[Table 3]

(Principle parameters)

$\lambda = 13.5$ nm

$\beta = 1/4$

NA = 0.2

H0 = 123.2 mm

$\phi = 30.8$ mm

LX = 26 mm

LY = 1.6 mm

(Optical member parameters)

Surface number

| | r | d | |
|---|---|---|---|
| (Mask surface) | | 667.196541 | |
| 1 | -802.22590 | -224.525594 | (First reflecting mirror M1) |
| 2 | $\infty$ | -105.148134 | (Aperture stop AS) |
| 3 | 3000.00000 | 105.048134 | (Second reflecting mirror M2) |
| 4 | 266.77177 | -280.541999 | (Third reflecting mirror M3) |
| 5 | 550.14959 | 1021.966625 | (Fourth reflecting mirror M4) |
| 6 | 583.14150 | -389.319673 | (Fifth reflecting mirror M5) |
| 7 | 483.86136 | 427.319673 | (Sixth reflecting mirror M6) |
| (Wafer surface) | | | |

(Aspheric surface data)

First surface

$\kappa = 0.000000$

$C_4 = 0.340529 \times 10^{-9}$     $C_6 = -0.342668 \times 10^{-14}$

$C_8 = 0.659070 \times 10^{-19}$     $C_{10} = -0.993138 \times 10^{-24}$

Third surface

$\kappa = 0.000000$

$C_4 = -0.101329 \times 10^{-7}$     $C_6 = 0.152043 \times 10^{-12}$

$C_8 = -0.720166 \times 10^{-17}$  $C_{10} = 0.428521 \times 10^{-21}$

Fourth surface

$\kappa = 0.000000$

$C_4 = -0.183771 \times 10^{-7}$  $C_6 = 0.113126 \times 10^{-12}$

$C_8 = -0.399771 \times 10^{-17}$  $C_{10} = 0.102190 \times 10^{-21}$

Fifth surface

$\kappa = 0.000000$

$C_4 = -0.127462 \times 10^{-9}$  $C_6 = -0.359385 \times 10^{-15}$

$C_8 = -0.762347 \times 10^{-21}$  $C_{10} = -0.509371 \times 10^{-26}$

Sixth surface

$\kappa = 0.000000$

$C_4 = 0.867056 \times 10^{-8}$  $C_6 = 0.187263 \times 10^{-12}$

$C_8 = -0.161606 \times 10^{-17}$  $C_{10} = 0.431953 \times 10^{-21}$

Seventh surface

$\kappa = 0.000000$

$C_4 = 0.114806 \times 10^{-9}$  $C_6 = 0.501739 \times 10^{-15}$

$C_8 = 0.337364 \times 10^{-20}$  $C_{10} = -0.215229 \times 10^{-26}$

(Conditional equation corresponding value)

$\phi M4 = 492.220$ mm

$R4 = 550.14959$ mm

(1) A = 23.96°

(2) $\phi M / |R| = 0.895$ (maximum at the fourth reflecting mirror M4)

(3) $|\alpha| = 5.61°$ (98 mrad)

(4) $\phi M = 492.220$ mm (maximum at the fourth reflecting mirror M4)

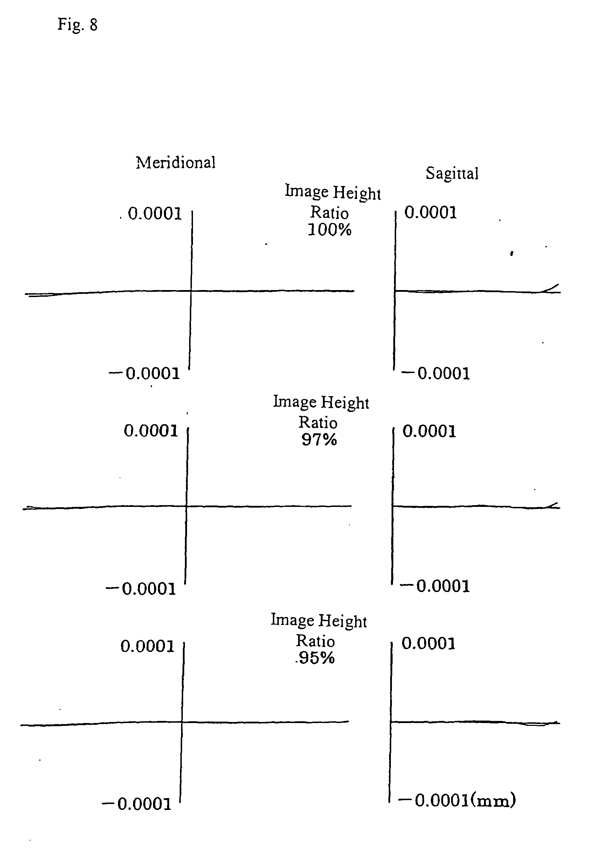

Fig. 8 is a figure showing coma in the projection optical system of the third exemplary embodiment. Fig. 8 shows meridional comas and sagittal comas at an image height of 100%, 97% and 95%, respectively. As is clear from the aberration diagrams, in the third exemplary embodiment, similar to the first and second exemplary embodiments, it is understood that the coma is corrected well in regions corresponding to the effective exposure region ER. In addition, although omitted from the drawing, it has been confirmed that various aberrations other than the coma, such as spherical aberration and distortions, are excellently corrected in the regions corresponding to the effective exposure region ER.

As described above, in each of the exemplary embodiments, with respect to the laser plasma X ray having a wavelength of 13.5 nm, the image-side numerical aperture can be secured at 0.26 and 0.2, and a circular arc shaped effective exposure region having a size of 26 mm x 2 mm or 26 mm x 1.6 mm in which various aberrations are well corrected can be secured on the wafer 7. Therefore, on the wafer 7, the pattern of the mask 4 can be transferred at a high resolution at equal to or less than 0.1 μm by scanning exposure, in each exposure region that has a size of 26 mm × 33 mm, for example.

In addition, the effective diameter of the fourth concave reflective mirror M4, which is the largest, is approximately about 492 mm to about 495 mm in each of the above-described exemplary embodiments, which is sufficiently small. As described above, in each of the exemplary embodiments, the sizes of the reflective mirrors are small, and thus the optical system is made small. Moreover, it generally becomes difficult to manufacture the optical system with high precision if the curvature radius of the reflective mirrors becomes large, thereby becoming flat. However, since the curvature radius R2 of the second concave reflective mirror M2, which has the largest curvature radius, is controlled at 3,000 mm in each of the above-described embodiment, the manufacturing of each reflective surface can be performed excellently.

Furthermore, in each of the above-described exemplary embodiments, because the angle α defined between the light beam group incident to and reflected from the mask and the optical axis AX is controlled to be as small as about 6°, it is hardly effected by shadows caused by the reflection, and therefore it hardly worsens the performance. In addition, there is an advantage that a large change in magnification is not introduced even if small errors occur at the position at which the mask is set.

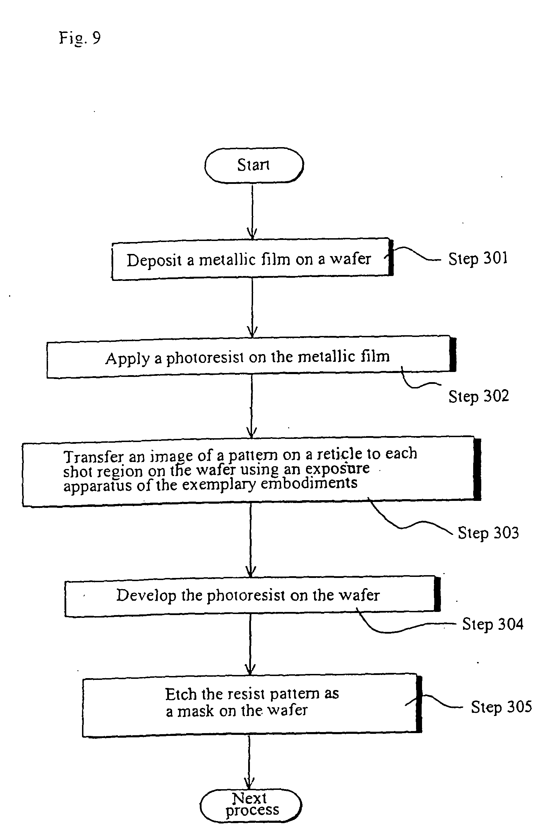

Using the exposure apparatus according to the above-described exemplary embodiments, micro devices (e. g., semiconductor elements, photo-shooting elements (such as CCDs and photodiodes), liquid crystal display elements, and thin film magnetic heads) can be manufactured by illuminating a mask with illumination light (illumination process) and by transferring a pattern formed on the mask onto a photosensitive substrate using the projection optical system (exposure process). The following explains, with reference to a flow chart shown in Fig. 9, an example of a manufacturing process for obtaining a semiconductor device as the micro device by forming a predetermined circuit pattern on a wafer or the like as the photosensitive substrate using the exposure apparatus of any of the exemplary embodiments.

First, in step 301 in Fig. 9, a metallic film is deposited on a wafer. In the next step 302, a photoresist is applied on the metallic film on the wafer. Thereafter, in step 303, an image of the pattern on the mask (reticle) is sequentially exposed and transferred to each shot region of the wafer, through the projection optical system.

After the photoresist on the wafer is developed in step S304, a circuit pattern corresponding to the pattern on the mask is formed in each shot region of each wafer by etching the resist pattern as a mask on the wafer in step 305. Thereafter, by performing formation of the circuit pattern on upper layer and the like, the device of semiconductor elements and the like is produced. According to the above-described semiconductor device manufacturing method, semiconductor devices having extremely fine circuit patterns can be obtained with excellent throughput.

In the above-described exemplary embodiments, a laser plasma X ray source is used as a light source for providing X rays. However, this invention is not limited to this, and a synchrotron radiation (SOR) light, for example, also can be used as the X rays.

Moreover, in the above-described exemplary embodiments, this invention is applied to an exposure apparatus that has a light source for providing X rays. However, this invention is not limited to this, and this invention also can be applied to an exposure apparatus that has a light source that provides light, other than X rays, having other wavelengths.

Furthermore, in the above-described exemplary embodiments, the invention is applied to a projection optical system of the exposure apparatus. However, this invention is not limited to this, and this invention also can be applied to other general projection optical systems.

As described above, in the projection optical system of aspects of this invention, since an aperture stop is positioned between the first reflective mirror and the second reflective mirror, an incident angle of the light beam to the third reflective mirror, in which an incident angle of the light beam tends to increase, can be controlled small. As a result, in the reflective multi-layer film, uneven reflection hardly occurs, and sufficiently high reflectivity can be obtained. Thus, excellent reflection characteristics can be secured even with X rays. Moreover, by keeping the incident angle of the light beam to the third reflective mirror small, the effective diameter of the fourth reflective mirror, which has an effective diameter that tends to increase, can be kept small. That is, in this invention, a reflective type projection optical system can be realized that has excellent reflection characteristics with respect to X rays and can correct aberrations well while preventing enlargement of the reflective mirrors.

In addition, by applying the projection optical system of this invention to an exposure apparatus, X rays can be used as exposure light. In such a case, the pattern of a mask is projected and exposed on the photosensitive substrate as the mask and the photosensitive substrate are mutually moved with respect to the projection optical system. As a result, high precision micro devices can be manufactured under excellent exposure conditions using a scanning type exposure apparatus that has high resolution.

While the invention has been described with reference to preferred embodiments thereof, it is to be understood that the invention is not limited to the preferred embodiments or constructions. To the contrary, the invention is intended to cover various modifications and equivalent arrangements. In addition, while the various elements of the preferred embodiments are shown in various combinations and configurations, which are exemplary, other combinations and configurations, including more, less or only a single element, are also within the spirit and scope of the invention.

**Claims**

1.  A projection optical system for forming a reduced image on a first plane onto a second plane, comprising:

    a first reflective image forming optical system that forms an intermediate image of the first plane, and a second reflective image forming optical system that forms an image of the intermediate image of the second plane, wherein:

    the first reflective image forming optical system has, in order of an incidence of light from a side of the first plane, a first reflective mirror M1, an aperture stop, a second reflective mirror M2, a third reflective mirror M3, and a fourth reflective mirror M4, and
    the second reflective image forming optical system has, in order of the incidence of the light from the side of the first plane, a fifth reflective mirror M5 and a sixth reflective mirror M6.

2.  The projection optical system of claim 1, wherein a maximum incident angle A of a light beam to each of the reflective mirrors M1-M6 satisfies, at each of the reflective mirrors M1-M6, a condition.

$$A < 25°.$$

3.  The projection optical system of claim 1, wherein at each of the reflective mirrors M1-M6,

$$\phi M/|R|<1.0$$

    is satisfied, where $\phi M$ is an effective diameter of each of the reflective mirrors M1-M6 and R is a curvature radius of a reflective surface of each of the reflective mirrors M1-M6.

4.  The projection optical system of claim 1, wherein at each of the reflective e mirrors M1-M6

$$\phi M/|R|<1.0$$

    is satisfied, where $\phi M$ is an effective diameter of each of the reflective mirrors M1-M6 and R is a curvature radius of a reflective surface of each of the reflective mirrors M1-M6.

5.  The projection optical system of claim 1, wherein a slope $\alpha$ of luminous flux from the first plane to the first reflective mirror M1 with respect to an optical axis of a main light beam satisfies

$$5°<|\alpha| < 10°.$$

6.  The projection optical system of claim 2, wherein a slope $\alpha$ of luminous flux from the first plane to the first reflective mirror M1 with respect to an optical axis of a main light beam satisfies

$$5°<|\alpha| < 10°.$$

7.  The projection optical system of claim 3, wherein a slope $\alpha$ of luminous flux from the first plane to the first reflective mirror M1 with respect to an optical axis of a main light beam satisfies

$$5°<|\alpha| < 10°.$$

8.  The projection optical system of claim 4, wherein a slope $\alpha$ of luminous flux from the fist plane to the first reflective mirror M1 with respect to an optical axis of a main light beam satisfies

$$5° < |\alpha| < 10°.$$

9. The projection optical system of one of claims 1 to 8, wherein at each of the reflective mirrors M1-M6, the effective diameter $\phi$M of each of the reflective mirrors M1-M6 satisfies

$$\phi M \leq 700 \text{ mm.}$$

10. The projection optical system of one of claims 1 to 9, wherein a reflective surface of each of the reflective mirrors M1-M6 is formed rotationally symmetrical with respect to an optical axis of a main light beam and is aspheric, and a largest order of an aspheric surface defining each reflective surface is equal to or more than $10^{th}$ order.

11. The projection optical system of one of claims 1-3, 5, 9, 10, wherein the projection optical system is substantially telecentric on the second plane side.

12. An exposure apparatus, comprising an illumination system for illuminating a mask provided on a first plane, and the projection optical system of one of claims 1-3, 5, 9, 10, 11 for projecting and exposing a pattern of the mask onto a photosensitive substrate provided on a second plane.

13. The exposure apparatus of claim 12, wherein the illumination system has a light source for providing X rays as exposure light, and
the pattern of the mask is projected and exposed onto the photosensitive substrate by synchronously moving the mask and the photosensitive substrate with respect to the projection optical system.

14. A projection optical system for forming a reduced image on a first plane onto a second plane, comprising:

a reflective image forming optical system that forms an intermediate image of the first plane, and a second reflective image forming optical system that forms an image of the intermediate image on the second plane, wherein:

the first reflective image forming optical system has, in order of an incidence of light from a side of the first plane, a first concave reflective mirror M1, an aperture stop, a second concave reflective mirror M2, a third convex reflective mirror M3, and a fourth concave reflective mirror M4, and
the second reflective image forming optical system has, in order of the incidence of the light from the side of the first plane, a fifth convex reflective mirror M5 and a sixth concave reflective mirror M6.

15. The projection optical system of claim 14, wherein a maximum incident angle A of a light beam to each of the reflective mirrors M1-M6 satisfies, at each of the reflective mirrors M1-M6, a condition

$$A < 25°.$$

16. The projection optical system of claim 14, wherein at each of the reflective mirrors M1-M6,

$$\phi M/|R| < 1.0$$

is satisfied, where $\phi$M is an effective diameter of each of the reflective mirrors M1-M6 and R is a curvature radius of a reflective surface of each of the reflective mirrors M1-M6.

17. The projection optical system of claim 14, wherein a slope $\alpha$ of luminous flux from the first plane to the first reflective mirror M1 with respect to an optical axis of a main light beam satisfies

$$5° < |\alpha| < 10°.$$

18. The projection optical system of claim 14, wherein at each of the reflective mirrors M1-M6, the effective diameter

$\phi$M of each of the reflective mirrors M1-M6 satisfies

$$\phi M \leq 700 \text{ mm.}$$

19. The projection optical system of claim 14, wherein a reflective surface of each of the reflective mirrors M1-M6 is formed rotationally symmetrical with respect to an optical axis of a main light beam and is aspheric, and
   a largest order of an aspheric surface defining each reflective surface is equal to or more than $10^{th}$ order.

20. The projection optical system of claim 14, wherein the projection optical system is substantially telecentric on the second plane side.

21. An exposure apparatus, comprising an illumination system for illuminating a mask provided on a first plane, and
   the projection optical system of claim 14 for projectiong and exposing a pattern of the mask onto a photosensitive substrate provided on a second plane.

22. The exposure apparatus of claim 21, wherein the illumination system has a light source for providing X rays as exposure light, and
   the pattern of the mask is projected and exposed onto the photosensitive substrate by synchronously moving the mask and the photosensitive substrate with respect to the projection optical system.

Fig. 1

Fig. 2

Fig. 3

Fig. 4

Meridional

Sagittal

Image Height
Ratio
100%

0.0001

0.0001

−0.0001

−0.0001

Image Height
Ratio
97%

0.0001

0.0001

−0.0001

−0.0001

Image Height
Ratio
94%

0.0001

0.0001

−0.0001

−0.0001(mm)

Fig. 5

Fig. 6

Meridional        Sagittal

Image Height Ratio 100%

Image Height Ratio 97%

Image Height Ratio 94%

Fig. 7

Fig. 8

Meridional                              Sagittal

                        Image Height
          0.0001          Ratio          0.0001
                          100%

          −0.0001                        −0.0001

                        Image Height
          0.0001          Ratio          0.0001
                          97%

          −0.0001                        −0.0001

                        Image Height
          0.0001          Ratio          0.0001
                          .95%

          −0.0001                        −0.0001(mm)

Fig. 9

Start

Deposit a metallic film on a wafer — Step 301

Apply a photoresist on the metallic film — Step 302

Transfer an image of a pattern on a reticle to each shot region on the wafer using an exposure apparatus of the exemplary embodiments — Step 303

Develop the photoresist on the wafer — Step 304

Etch the resist pattern as a mask on the wafer — Step 305

Next process